# EUROPEAN PATENT APPLICATION

(11) **EP 4 518 634 A1**
(43) Date of publication of application: **05.03.2025**
(21) Application number: 24194701.9
(22) Date of filing: 15.08.2024
(51) Int. Cl.: H10K 59/80, H10K 102/00

(54) **DISPLAY DEVICE AND METHOD OF MANUFACTURING THE SAME**

(30) Priority: 22.08.2023 KR 20230109575
(71) Applicant: Samsung Display Co., Ltd., Gyeonggi-do 17113 (KR)
(72) Inventor: Park, Yong Jun, 17113 Giheung-gu, Yongin-si, Gyeonggi-do (KR); Lee, Young Suk, 17113 Giheung-gu, Yongin-si, Gyeonggi-do (KR)
(74) Representative: Dr. Weitzel & Partner

(57) **Abstract**

A display device includes: a light emitting element layer including at least one light emitting device to emit light; a light transmitting film on the light emitting element layer, the light transmitting film having a first refractive index, and defining openings; a light blocking pattern on the light emitting element layer and in the openings; and a low refractive film on the light transmitting film, the low refractive film having a second refractive index smaller than the first refractive index, and including refractors inclined to have an inclination angle with respect to an imaginary line perpendicular to an upper surface of the light transmitting film.

## Description

### BACKGROUND

### 1. Field

The present invention relates to a display device, and a method of manufacturing the display device.

### 2. Description of the Related Art

A display device is a device including a display area that displays an image. Recently, the need for display devices in which a viewing angle of the images displayed in the display area is controlled is increasing.

For example, as the display device is frequently used in public places, it may be desirable for the viewing angle of the image displayed in the display area to be controlled, so that people other than the user cannot see the image displayed in the display area. As another example, controlling the viewing angle of an image displayed in the display area of a vehicle display device may be desired.

The above information disclosed in this Background section is for enhancement of understanding of the background of the present invention, and therefore, it may contain information that does not constitute prior art.

### SUMMARY

One or more embodiments of the present invention are directed to a display device with a controlled viewing angle. One or more embodiments of the present invention are directed to a display device with improved light extraction efficiency.

One or more embodiments of the present invention are directed to a method of manufacturing the display device.

The invention is defined by the independent claims. The dependent claims describe preferred embodiments.

According to the present invention, a display device includes: a light emitting element layer including at least one light emitting device configured to emit light; a light transmitting film on the light emitting element layer, the light transmitting film having a first refractive index, and defining openings; a light blocking pattern on the light emitting element layer and in the openings; and a low refractive film on the light transmitting film, the low refractive film having a second refractive index smaller than the first refractive index, and including refractors inclined to have an inclination angle with respect to an imaginary line perpendicular to an upper surface of the light transmitting film.

In an embodiment, the first refractive index may be about 1.4 or more, and the second refractive index may be about 1.3 or less.

In an embodiment, each of the refractors may include a material having a third refractive index greater than the second refractive index.

In an embodiment, each of the refractors may include an inorganic material.

In an embodiment, each of the refractors may include at least one of a metal compound or an inorganic insulating material.

In an embodiment, each of the refractors may include at least one of magnesium fluoride (MgF₂), titanium dioxide (TiO₂), silicon oxide, silicon nitride, or silicon oxynitride.

In an embodiment, in a plan view, the low refractive film may overlap with the light transmitting film, and may be spaced from the light blocking pattern.

In an embodiment, the low refractive film may not be located in the openings.

In an embodiment, the display device may further include a planarization layer on the light transmitting film and the light blocking pattern, and covering the refractors.

In an embodiment, the low refractive film may further include a cavity defined between the refractors, and the cavity of the low refractive film may be filled by the planarization layer.

In an embodiment, the light blocking pattern may include at least one of a black pigment, a black dye, or molybdenum-tantalum oxide (MTO).

According to the present invention, a method of manufacturing a display device, includes: forming a light emitting element layer on a substrate, the light emitting layer including at least one light emitting element configured to emit light; forming a light transmitting film on the light emitting element layer, the light transmitting film having a first refractive index and defining openings; forming a low refractive film on the light transmitting film, the low refractive film having a second refractive index smaller than the first refractive index, and including refractors inclined to have an inclination angle with respect to an imaginary line perpendicular to an upper surface of the light transmitting film; and forming a light blocking pattern in the openings.

In an embodiment, the low refractive film may not be formed in the openings.

In an embodiment, in the forming of the low refractive film, the low refractive film may be deposited on the light transmitting film by arranging the substrate to be inclined with respect to an imaginary line perpendicular to a surface from which a deposition material used to deposit the low refractive film is emitted.

In an embodiment, in the forming of the low refractive film, the low refractive film may be deposited by additionally disposing an auxiliary plate to control a direction of progress of the deposition material between the surface from which the deposition material is emitted and the substrate.

In an embodiment, the auxiliary plate may have a mesh shape.

In an embodiment, the deposition material may have a third refractive index greater than the second refractive index.

In an embodiment, the deposition material may include an inorganic material.

In an embodiment, the deposition material may include at least one of a metal compound or an inorganic insulating material.

In an embodiment, the method may further include forming a planarization layer on the light transmitting film to cover the refractors.

In an embodiment, the method may further include: forming a sacrificial layer on the low refractive film; forming a dummy light blocking pattern on the sacrificial layer; and removing the dummy light blocking pattern by removing the sacrificial layer. The dummy light blocking pattern may be formed in the same process as that of the light blocking pattern.

In an embodiment, the sacrificial layer may not be formed in the openings.

In an embodiment, in the forming of the sacrificial layer, the sacrificial layer may be deposited on the low refractive film by arranging the substrate to be inclined with respect to an imaginary line perpendicular to a surface from which a deposition material used to deposit the sacrificial layer is emitted.

In an embodiment, in the removing of the dummy light blocking pattern, the sacrificial layer may be removed by an etching process.

In an embodiment, the sacrificial layer may be formed to have a first etch rate with respect to the etching process, and the low refractive film may be formed to have a second etch rate smaller than the first etch rate with respect to the etching process.

In an embodiment, the dummy light blocking pattern may be spaced from the light blocking pattern.

In an embodiment, the low refractive film and the light blocking pattern may remain after removing the dummy light blocking pattern by removing the sacrificial layer.

According to one or more embodiments of the present invention, a display device may include a light transmitting film disposed on a light emitting element layer and defining openings, and light blocking patterns disposed in the openings. The light blocking patterns may control a viewing angle of the light emitted from the light emitting layer.

According to one or more embodiments of the present invention, a display device may include a low refractive film disposed on the light transmitting film, and including the refractors inclined to have an inclination angle (e.g., a predetermined inclination angle). Accordingly, the low refractive film may have a refractive index smaller than a refractive index of the light transmitting film. As such, the low refractive film may control a path of the light emitted from the light emitting layer and passing through the light transmitting film. In addition, the low refractive film may improve a luminous efficiency of the display device. Further, a light extraction efficiency of the display device may be improved.

According to one or more embodiments of the present invention, in a method of manufacturing the display device, the low refractive film may be formed through an inclined deposition method. Because the low refractive film is formed through the inclined deposition method, the low refractive film may be selectively formed on the upper surface of the light transmitting film.

According to one or more embodiments of the present invention, as the low refractive film may be formed through the inclined deposition method, even when the low refractive film is formed using a material with a refractive index greater than a refractive index of the light transmitting film, the low refractive film may have a lower refractive index than the refractive index of the light transmitting film. Accordingly, a diversity of materials that can be used as the low refractive film may be secured. In addition, it may be easier to implement the low refractive film by adopting a material that can reduce or prevent damage during the manufacturing process of the display device. Further, the display device may be manufactured more easily.

According to one or more embodiments of the present invention, in a method of manufacturing the display device, a sacrificial layer may be formed on the low refractive film, dummy light blocking patterns may be formed on the sacrificial layer, and the dummy light blocking patterns may be removed by removing the sacrificial layer. Accordingly, even when a polishing process is omitted, an upper surface of each of the light blocking patterns may be formed at (e.g., in or on) the same or substantially the same plane as that of an upper surface of the light transmitting film. In other words, even when the polishing process is omitted, the plane on which the upper surface of each of the light blocking patterns and the upper surface of the light transmitting film are formed may be implemented to be flat or substantially flat. As such, even when the polishing process is omitted, materials used to form the light blocking patterns may not remain or substantially remain on the upper surface of the light transmitting film.

According to one or more embodiments of the present invention, the polishing process for forming the light blocking patterns may be omitted. Accordingly, the upper surface of the light transmitting film may not be damaged by the polishing process. As such, surface characteristics of the upper surface of the light transmitting film may be improved. Further, reliability of the display device may be improved, and light extraction efficiency of the display device may be improved.

It is to be understood that both the foregoing general description and the following detailed description are example embodiments and explanatory in nature, and thus, are intended to provide a further explanation of the present invention as claimed below.

### BRIEF DESCRIPTION OF THE DRAWINGS

The above and other aspects and features of the present invention will be more clearly understood from the following detailed description of the illustrative, nonlimiting embodiments with reference to the accompanying drawings.
FIG. 1 is a plan view illustrating a display device according to an embodiment.
FIG. 2 is an enlarged view of a pixel area of the display device of FIG. 1.
FIG. 3 is a cross-sectional view taken along the line I-I' of FIG. 2.
FIG. 4 is an enlarged view of the area A of FIG. 3.
FIGS. 5-13 are various views illustrating a manufacturing method of the display device of FIG. 1.

### DETAILED DESCRIPTION

Hereinafter, embodiments will be described in more detail with reference to the accompanying drawings, in which like reference numbers refer to like elements throughout. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Accordingly, processes, elements, and techniques that are not necessary to those having ordinary skill in the art for a complete understanding of the aspects and features of the present invention may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the the present invention.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present invention. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present invention refers to "one or more embodiments of the present invention." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

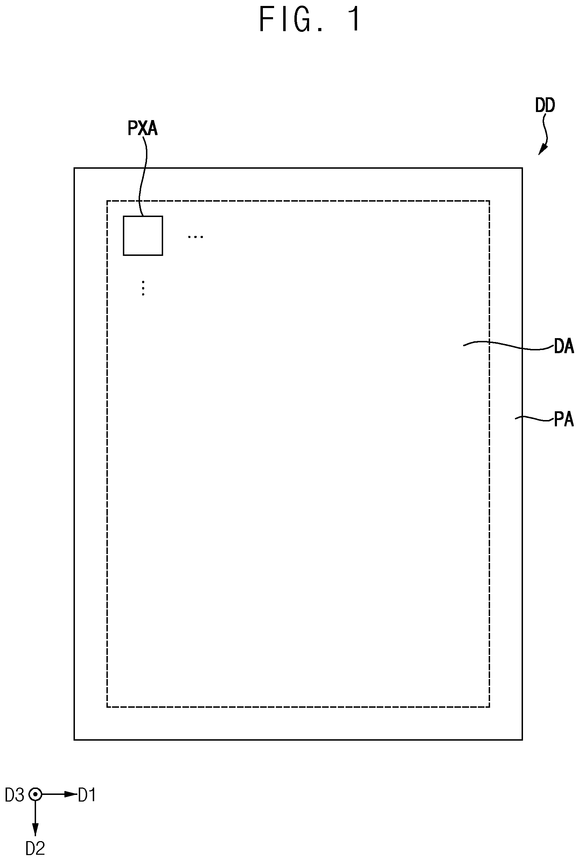

FIG. 1 is a plan view illustrating a display device according to an embodiment.

Referring to FIG. 1, a display device DD according to an embodiment may be divided into a display area DA and a peripheral area PA. The display area DA may display an image, and the peripheral area PA may be located around (e.g., adjacent to) the display area DA. For example, the peripheral area PA may surround (e.g., around a periphery of) the display area DA.

In an embodiment, the display device DD may have a rectangular shape in a plan view. However, the present invention is not limited thereto, and the display device DD may have various suitable shapes in the plan view. As used herein, a plane may be defined by a first direction D1 and a second direction D2 crossing or intersecting the first direction D1. For example, the first direction D1 and the second direction D2 may be perpendicular to or substantially perpendicular to each other. A third direction D3 may be perpendicular to or substantially perpendicular to the plane. In other words, the third direction D3 may be a normal direction of the plane.

The display device DD may include a plurality of pixel areas PXA disposed in the display area DA. For example, the pixel areas PXA may be arranged in a matrix form along the first direction D1 and the second direction D2.

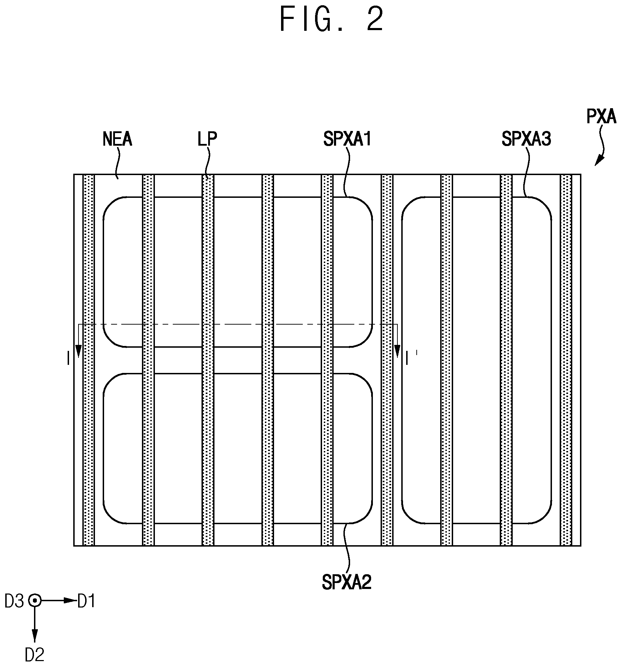

FIG. 2 is an enlarged view of the pixel area of the display device of FIG. 1.

Referring to FIGS. 1 and 2, each of the pixel areas PXA may include first to third sub-pixel areas SPXA1, SPXA2, and SPXA3, and a non-emission area NEA surrounding (e.g., around peripheries of) the first to third sub-pixel areas SPXA1, SPXA2, and SPXA3. The first to third sub-pixel areas SPXA1, SPXA2, and SPXA3 may emit light of different colors from each other. For example, the first sub-pixel area SPXA1 may emit red light, the second sub-pixel area SPXA2 may emit green light, and the third sub-pixel area SPXA3 may emit blue light. However, the present invention is not limited thereto, and the first to third sub-pixel areas SPXA1, SPXA2, and SPXA3 may be combined with one another, so that each of the pixel areas PXA emits yellow, cyan, and/or magenta light.

In an embodiment, an arrangement structure of the first to third sub-pixel areas SPXA1, SPXA2, and SPXA3 may be an S-stripe structure. For example, the first sub-pixel area SPXA1 and the second sub-pixel area SPXA2 may be disposed in a first column, and the third sub-pixel area SPXA3 may be disposed in a second column adjacent to the first column. In this case, one side of each of the first sub-pixel area SPXA1 and the second sub-pixel area SPXA2 may be arranged to face a long side of the third sub-pixel area SPXA3. However, the present invention is not limited thereto, and a planar arrangement of the first to third sub-pixel areas SPXA1, SPXA2, and SPXA3 may be variously modified as needed or desired.

In FIG. 2, each of the pixel areas PXA is illustrated as having the first to third sub-pixel areas SPXA1, SPXA2, and SPXA3, but the present invention is not limited thereto. For example, in another embodiment, each of the pixel areas PXA may have two sub-pixel areas, four sub-pixel areas, or more sub-pixel areas.

In an embodiment, the display device DD may include light blocking patterns LP. The light blocking patterns LP may extend in the first direction D2. In an embodiment, the light blocking patterns LP may be arranged side by side with one another in a plan view. For example, the light blocking patterns LP may be spaced apart from each other in the first direction D1. In other words, the light blocking patterns LP may be parallel to or substantially parallel to each other. However, the arrangement of the light blocking patterns LP is not limited thereto.

The light blocking patterns LP may control a viewing angle of the light emitted from each of the first to third sub-pixel areas SPXA1, SPXA2, and SPXA3. In an embodiment, the light blocking patterns LP may be arranged to overlap with the first to third sub-pixel areas SPXA1, SPXA2, and SPXA3 in a plan view. However, the present invention is not limited thereto. For example, the light blocking patterns LP may be arranged to be spaced apart from the first to third sub-pixel areas SPXA1, SPXA2, and SPXA3, and to overlap with the non-emission area NEA in a plan view. In other words, the light blocking patterns LP may be disposed between the first to third sub-pixel areas SPXA1, SPXA2, and SPXA3 in a plan view. As another example, the light blocking patterns LP may overlap with at least one sub-pixel area of the first to third sub-pixel areas SPXA1, SPXA2, and/or SPXA3, and may be spaced apart from at least one sub-pixel area of the other remaining sub-pixel areas.

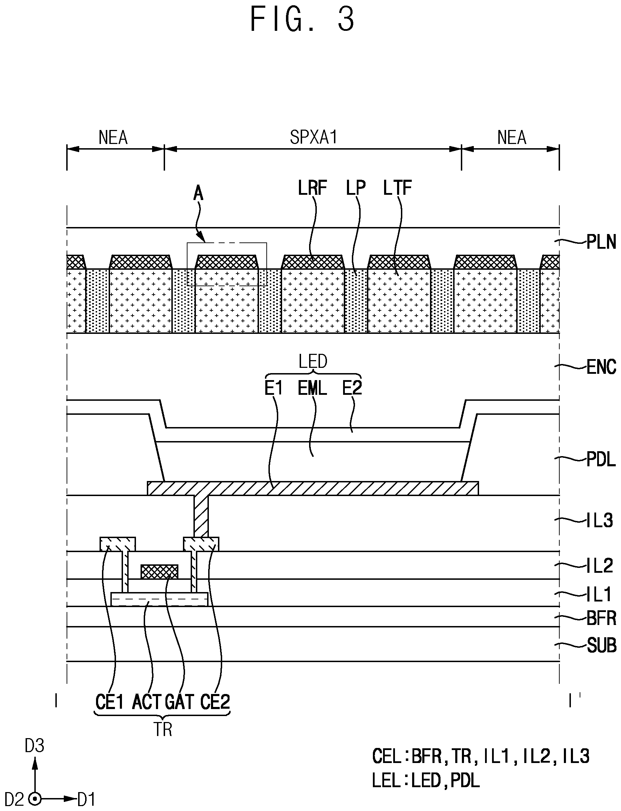

FIG. 3 is a cross-sectional view taken along the line I-I' of FIG. 2.

For convenience, in FIG. 3, a cross-sectional structure of the first sub-pixel area SPXA1 is illustrated. The cross-sectional structure of each of the second sub-pixel area SPXA2 and the third sub-pixel area SPXA3 may be the same or substantially the same as the cross-sectional structure of the first sub-pixel area SPXA1. Accordingly, redundant description of the cross-sectional structure of each of the second sub-pixel area SPXA2 and the third sub-pixel area SPXA3 may not be repeated.

Referring to FIG. 3, the display device DD may include a substrate SUB, a circuit element layer CEL, a light emitting element layer LEL, an encapsulation layer ENC, a light transmitting film LTF, the light blocking patterns LP, a low refractive film LRF, and a planarization layer PLN.

The substrate SUB may include a transparent or opaque material. In an embodiment, examples of the materials that may be used as the substrate SUB may include glass, quartz, plastic, or the like. These materials may be used alone or in suitable combinations with each other.

The circuit element layer CEL may be disposed on the substrate SUB. The circuit element layer CEL may include a buffer layer BFR, a driving element TR, and first to third insulating layers IL1, IL2, and IL3. The driving element TR may include an active pattern ACT, a gate electrode GAT, a first connection electrode CE1, and a second connection electrode CE2.

The buffer layer BFR may be disposed on the substrate SUB. The buffer layer BFR may prevent or substantially prevent impurities, such as oxygen and/or moisture, from diffusing into an upper part of the substrate SUB. The buffer layer BFR may include an inorganic material. Examples of the inorganic material that may be used as the buffer layer BFR may include silicon oxide, silicon nitride, and silicon oxynitride. These materials may be used alone or in suitable combinations with each other. The buffer layer BFR may have a single-layer structure, or a multi-layered structure including a plurality of insulating layers.

The active pattern ACT may be disposed on the buffer layer BFR. In an embodiment, the active pattern ACT may include a silicon semiconductor material or an oxide semiconductor material. Examples of the silicon semiconductor material that may be used as the active pattern ACT may include amorphous silicon, polycrystalline silicon, or the like. Examples of the oxide semiconductor material that may be used as the active pattern ACT may include InGaZnO (IGZO), InSnZnO (ITZO), or the like.

In an embodiment, the first insulating layer IL1 may be disposed on the buffer layer BFR. The first insulating layer IL1 may cover the active pattern ACT. In another embodiment, the first insulating layer IL1 may be arranged in a pattern form on the active pattern ACT to expose a portion of the active pattern ACT. For example, the first insulating layer IL1 may be arranged in a pattern form on the active pattern ACT so as to overlap with the gate electrode GAT. The first insulating layer IL1 may include an inorganic insulating material. Examples of the inorganic insulating material that may be used as the first insulating layer IL1 may include silicon oxide, silicon nitride, and silicon oxynitride. These materials may be used alone or in suitable combinations with each other.

The gate electrode GAT may be disposed on the first insulating layer IL1. In an embodiment, the gate electrode GAT may include a metal, an alloy, a conductive metal oxide, a transparent conductive material, or the like.

The second insulating layer IL2 may be disposed on the first insulating layer IL1. In an embodiment, the second insulating layer IL2 may cover the gate electrode GAT. The second insulating layer IL2 may include an inorganic insulating material. Examples of the inorganic insulating material that may be used as the second insulating layer IL2 may include silicon oxide, silicon nitride, and silicon oxynitride. These materials may be used alone or in suitable combinations with each other.

The first connection electrode CE1 and the second connection electrode CE2 may be disposed on the second insulating layer IL2. The first connection electrode CE1 and the second connection electrode CE2 may be electrically connected to the active pattern ACT through contact holes formed in the first insulating layer IL1 and the second insulating layer IL2. Each of the first connection electrode CE1 and the second connection electrode CE2 may include a metal, an alloy, a conductive metal oxide, a transparent conductive material, or the like.

The third insulating layer IL3 may be disposed on the second insulating layer IL2. The third insulating layer IL3 may cover the first connection electrode CE1 and the second connection electrode CE2. The third insulating layer IL3 may include an organic insulating material. Examples of the organic insulating material that may be used as the third insulating layer IL3 may include a photoresist, a polyacryl-based resin, a polyimide-based resin, a polyamide-based resin, a siloxane-based resin, an acryl-based resin, an epoxy-based resin, or the like. These materials may be used alone or in suitable combinations with each other. The third insulating layer IL3 may have a single-layer structure, or a multi-layered structure including a plurality of insulating layers.

The structure of the circuit element layer CEL described above with reference to FIG. 3 is an example, and may be variously modified as would be understood by those having ordinary skill in the art.

The light emitting element layer LEL may be disposed on the circuit element layer CEL. The light emitting element layer LEL may include a pixel defining layer PDL and a light emitting element LED. The light emitting element LED may include a pixel electrode E1, an emission layer EML, and a common electrode E2. The light emitting element LED may be driven by the driving element TR.

The pixel electrode E1 may be disposed on the third insulating layer IL3. The pixel electrode E1 may be electrically connected to the driving element TR through a contact hole formed in the third insulating layer IL3. In an embodiment, the pixel electrode E1 may include a metal, an alloy, a conductive metal oxide, a transparent conductive material, or the like.

In an embodiment, a third connection electrode and a fourth insulating layer may be additionally disposed between the third insulating layer IL3 and the pixel electrode E1. The third connection electrode may be in contact with the first connection electrode CE1 or the second connection electrode CE2, and may include a metal, an alloy, a conductive metal oxide, a transparent conductive material, or the like. The fourth insulating layer may cover the third connection electrode, and may include an organic insulating material. In this case, the pixel electrode E1 may be in contact with the third connection electrode through a contact hole formed in the fourth insulating layer, and may be electrically connected to the driving element TR through the third connection electrode.

The pixel defining layer PDL may be disposed on the third insulating layer IL3. The pixel defining layer PDL may define a pixel opening that exposes a portion of the pixel electrode E1. The first sub-pixel area SPXA1 may be defined by the pixel opening. In other words, the pixel defining layer PDL may be disposed in the non-emission area NEA. In an embodiment, the pixel defining layer PDL may include an organic insulating material. Examples of the organic insulating material that may be used as the pixel defining layer PDL may include a photoresist, a polyacrylic resin, a polyimide resin, an acrylic resin, or the like. These materials may be used alone or in suitable combinations with each other.

The emission layer EML may be disposed on the pixel electrode E1 in the pixel opening. The emission layer EML may include a suitable material that emits light. For example, the emission layer EML may include an organic light emitting material.

In an embodiment, one or more functional layers, such as a hole injection layer, a hole transport layer, an electron transport layer, and an electron injection layer, may be additionally disposed above and/or below the emission layer EML.

The common electrode E2 may be disposed on the emission layer EML. The common electrode E2 may include a conductive material, such as a metal, an alloy, a conductive metal nitride, a conductive metal oxide, or a transparent conductive material. The common electrode E2 may have a single-layer structure, or a multi-layered structure including a plurality of conductive layers. In an embodiment, the common electrode E2 may extend continuously across a plurality of pixels.

The encapsulation layer ENC may be disposed on the light emitting element layer LEL. The encapsulation layer ENC may cover the light emitting element LED. The encapsulation layer ENC may protect the light emitting element LED from external moisture, heat, shock, or the like. In some embodiments, the encapsulation layer ENC may include a first inorganic encapsulation layer, an organic encapsulation layer disposed on the first inorganic encapsulation layer, and a second inorganic encapsulation layer disposed on the organic encapsulation layer.

In an embodiment, the light transmitting film LTF may be disposed on the encapsulation layer ENC. The light transmitting film LTF may define openings that expose an upper surface of the encapsulation layer ENC. Each of the openings may be defined from an inner surface of the light transmitting film LTF. In other words, the openings may penetrate the light transmitting film LTF. In an embodiment, the light transmitting film LTF may have a grid shape in a plan view. The light transmitting film LTF may include an organic insulating material and/or an inorganic insulating material with a relatively high light transmittance.

In an embodiment, one or more additional functional layers may be disposed between the encapsulation layer ENC and the light transmitting film LTF. For example, a sensing layer that detects an external touch may be disposed between the encapsulation layer ENC and the light transmitting film LTF. In this case, the openings of the light transmitting film LTF may be defined to expose an upper surface of an immediately underlying insulating layer.

The light transmitting film LTF may have a first refractive index. The first refractive index may be about 1.1 or more. For example, the first refractive index may be about 1.1 to about 1.7. In more detail, the first refractive index may be about 1.4 or more. For example, the first refractive index may be about 1.4 to about 1.5. In an embodiment, the first refractive index may be smaller than a refractive index of the substrate SUB.

The light blocking patterns LP may be disposed on the encapsulation layer ENC. The light blocking patterns LP may be disposed in the openings defined in the light transmitting film LTF. Accordingly, the light transmitting film LTF may be disposed between the light blocking patterns LP. In other words, the light blocking patterns LP may expose an upper surface of the light transmitting film LTF.

In an embodiment, light emitted by the light emitting element LED may be incident on the light blocking patterns LP, or may pass between the light blocking patterns LP. Some of the light incident on the light blocking patterns LP may pass through the light blocking patterns LP. Some of the light incident on the light blocking patterns LP may be reflected by the light blocking patterns LP. Some of the light incident on the light blocking patterns LP may be absorbed by the light blocking patterns LP.

In an embodiment, most of the light incident on the light blocking patterns LP may be reflected or absorbed by the light blocking patterns LP. Accordingly, the light blocking patterns LP may control the viewing angle of the light emitted from the light emitting element LED.

The light blocking patterns LP may include various suitable materials that block light emitted from the light emitting element LED. Examples of the materials that may be used as the light blocking patterns LP may include a black pigment, a black dye, carbon black, chrome, or the like. These materials may be used alone or in suitable combinations with each other. Another example of a material that may be used as the light blocking patterns LP may include a metal oxide such as molybdenum-tantalum oxide (MTO).

The low refractive film LRF may be disposed on the light transmitting film LTF. In more detail, the low refractive film LRF may overlap with the light transmitting film LTF in a plan view. For example, the low refractive film LRF may be disposed on the upper surface of the light transmitting film LTF. For example, the low refractive film LRF may be disposed directly on the upper surface of the light transmission film LTF. Therefore, the low refractive film LRF and the light transmission film LTF may share an interface with each other.

The low refractive film LRF may not be disposed in the openings of the light transmitting film LTF. In other words, the low refractive film LRF may be selectively disposed on the upper surface of the light transmitting film LTF. For example, the low refractive film LRF may have a grid shape in a plan view. Additionally, the low refractive film LRF may be spaced apart from the light blocking patterns LP in a plan view. In other words, the low refractive film LRF may expose the light blocking patterns LP.

The low refractive film LRF may include a suitable material with a relatively high light transmittance. Accordingly, the light emitted from the light emitting element LED may be emitted to the outside through the light transmitting film LTF and the low refractive film LRF.

The low refractive film LRF may have a second refractive index. In an embodiment, the second refractive index may be smaller than the first refractive index of the light transmitting film LTF. For example, the second refractive index may be about 1.4 or less. In more detail, the second refractive index may be about 1.1 to about 1.4. For example, the second refractive index may be about 1.3 or less. In more detail, the second refractive index may be about 1.1 to about 1.3, or about 1.2 to about 1.3.

In an embodiment, a difference between the first refractive index and the second refractive index may be about 0.1 to about 0.6, or about 0.1 to about 0.3.

As the low refractive film LRF has the second refractive index smaller than the first refractive index of the light transmitting film LTF, the low refractive film LRF may control a path of the light emitted from below. In other words, the low refractive film LRF may control the path of the light emitted from the light emitting element LED and passing through the light transmitting film LTF. For example, the path of the light may be changed due to a difference in the refractive index at the interface between the light transmitting film LTF and the low refractive film LRF. For example, the low refractive film LRF may change the path of the light that is obliquely incident to the third direction D3. Accordingly, the low refractive film LRF may improve a luminous efficiency of the display device DD.

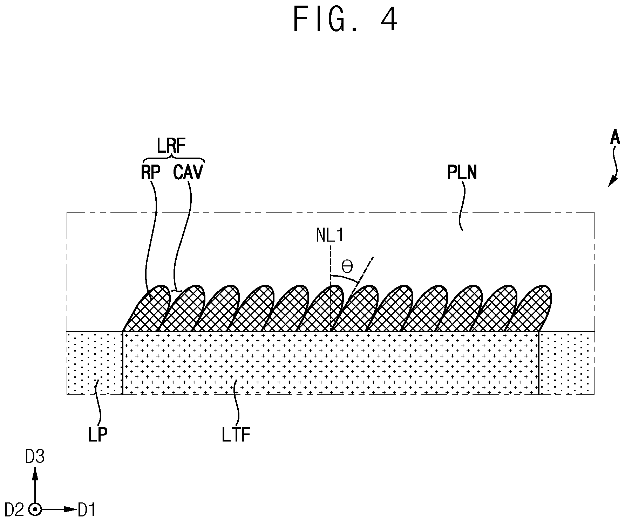

The low refractive film LRF will be described in more detail below with reference to FIG. 4.

The planarization layer PLN may cover the light transmitting film LTF, the light blocking patterns LP, and the low refractive film LRF. The planarization layer PLN may have a flat or substantially flat upper surface. In an embodiment, the planarization layer PLN may include the same material as that of the light transmitting film LTF. For example, the planarization layer PLN may include an organic insulating material and/or an inorganic insulating material with a high light transmittance.

FIG. 4 is an enlarged view of the area A of FIG. 3.

The structure of the low refractive film LRF will be described in more detail hereinafter with further reference to FIG. 4.

Referring to FIGS. 3 and 4, the low refractive film LRF may include a plurality of refractors RP. The refractors RP may be units that form the low refractive film LRF. The refractors RP may be disposed on the light transmitting film LTF. In more detail, the refractors RP may overlap with the light transmitting film LTF in a plan view. For example, the refractors RP may be disposed on the upper surface of the light transmitting film LTF. For example, the refractors RP may be disposed directly on the upper surface of the light transmitting film LTF. Accordingly, the refractors RP and the light transmitting film LTF may share an interface with each other.

The refractors RP may have a structure inclined at an angle (e.g., a certain or predetermined angle). For example, the refractors RP may be inclined to have an inclination angle θ with respect to an imaginary line NL1 perpendicular to the upper surface of the light transmitting film LTF. In this case, the imaginary line NL1 perpendicular to the upper surface of the light transmitting film LTF may be parallel to the third direction D3. As the refractors RP are inclined at the angle, the path of the light emitted from the light emitting element LED may be changed by the refractors RP.

The inclination angle θ of the refractors RP may be variously adjusted by variables, such as an injection direction, an injection speed, and/or a deposition direction, of a deposition material in a process according to an inclined deposition method described in more detail below.

In an embodiment, each of the refractors RP may include a suitable material having a third refractive index. In an embodiment, the third refractive index may be greater than the second refractive index of the low refractive film LRF. In other words, by having a structure where each of the refractors RP is inclined to have the inclination angle θ, the low refractive film LRF may have the second refractive index smaller than the third refractive index of the material included in each of the refractors RP. For example, even if each of the refractors RP includes the material having the third refractive index that is greater than or substantially greater than the first refractive index of the light transmitting film LTF, the low refractive film LRF itself may have the second refractive index smaller than the first refractive index of the light transmitting film LTF.

In other words, even when forming the low refractive film LRF using a suitable material having a higher refractive index than the first refractive index of the light transmitting film LTF, as the low refractive film LRF is formed in a structure including the refractors RP having the inclination angle θ, the low refractive film LRF may have a lower refractive index than that of the light transmission film LTF.

In an embodiment, the low refractive film LRF may further include a cavity CAV defined between the refractors RP. In other words, the cavity CAV may be defined from a space between the refractors RP. The cavity CAV may be filled by the planarization layer PLN. In other words, the planarization layer PLN may compensate for a step difference caused by the refractors RP. In other words, the planarization layer PLN may cover the refractors RP.

In an embodiment, each of the refractors RP may include an inorganic material. For example, each of the refractors RP may include a metal compound and/or an inorganic insulating material. Examples of the metal compound that may be used as the refractors RP may include magnesium fluoride MgF2 and titanium dioxide TiO2. These materials may be used alone or in suitable combinations with each other. Examples of the inorganic insulating material that may be used as the refractors RP may include silicon oxide, silicon nitride, and silicon oxynitride. These materials may be used alone or in suitable combinations with each other.

The shape of the refractors RP illustrated in FIG. 4 is an example, and may be variously modified as needed or desired. Additionally, in FIG. 4, the refractors RP are illustrated as being in contact with each other, but the present invention is not limited thereto. In other embodiments, the refractors RP may be spaced apart from each other.

The display device DD according to one or more embodiments may include the light transmitting film LTF disposed on the light emitting element layer LEL and defining the openings, and the light blocking patterns LP disposed in the openings. The light blocking patterns LP may control the viewing angle of the light emitted from the light emitting element LED.

Additionally, the display device DD may include the low refractive film LRF disposed on the light transmitting film LTF and including the refractors RP inclined to have a suitable inclination angle (e.g., a predetermined inclination angle). Accordingly, the low refractive film LRF may have a refractive index smaller than a refractive index of the light transmitting film LTF. As such, the low refractive film LRF may control the path of the light emitted from the light emitting element LED and passing through the light transmitting film LTF. In addition, the low refractive film LRF may improve a luminous efficiency of the display device DD. Further, a light extraction efficiency of the display device DD may be improved.

In addition, as the low refractive film LRF has the structure including the refractors RP inclined to have the inclination angle, even when the low refractive film LRF is formed using a material that has a refractive index greater than the refractive index of the light transmitting film LTF, the low refractive film LRF may have the refractive index smaller than the refractive index of the light transmitting film LTF. Accordingly, a diversity of the materials that may be used as the low refractive film LRF may be secured. Accordingly, it may be easier to implement the low refractive film LRF by adopting a suitable material that may reduce or prevent damage during a manufacturing process of the display device DD. As such, a reliability of the display device DD may be improved, and the display device DD may be manufactured more easily.

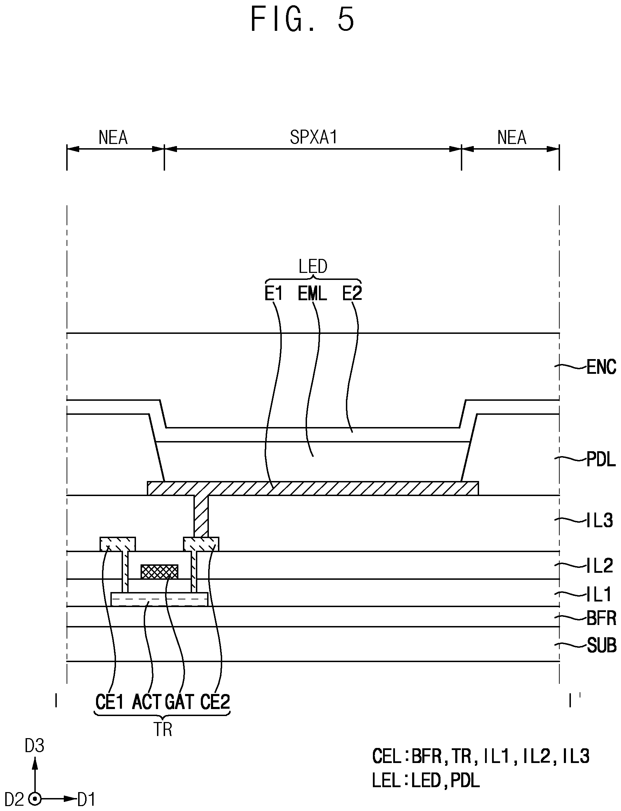

FIGS. 5 through 13 are various views illustrating a manufacturing method of the display device of FIG. 1.

Referring to FIG. 5, the circuit element layer CEL, the light emitting element layer LEL, and the encapsulation layer ENC may be formed on the substrate SUB. The components included in the circuit element layer CEL, the light emitting element layer LEL, and the encapsulation layer ENC may be formed through a suitable deposition process and a suitable patterning process (e.g., exposure and development process) as known to those having ordinary skill in the art.

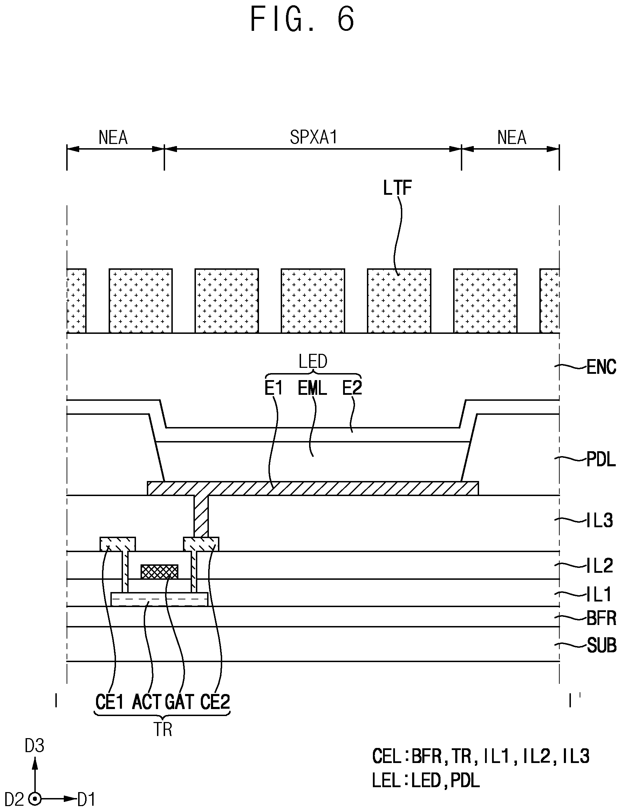

Referring to FIG. 6, the light transmitting film LTF may be formed on the encapsulation layer ENC. In an embodiment, the light transmitting film LTF may be formed by forming a preliminary light transmitting film first on the encapsulation layer ENC, and then patterning the preliminary light transmitting film through an exposure and development process. Accordingly, the light transmitting film LTF may define the openings that expose a portion of the encapsulation layer ENC as shown.

The light transmitting film LTF may be formed of a suitable material having the first refractive index. In other words, the light transmitting film LTF may be formed by applying the material having the first refractive index on the encapsulation layer ENC to form the preliminary light transmitting film, and then patterning the preliminary light transmitting film through an exposure and development process. Accordingly, the light transmitting film LTF may be formed to have the first refractive index. In an embodiment, the light transmitting film LTF may be formed of an organic insulating material and/or an inorganic insulating material.

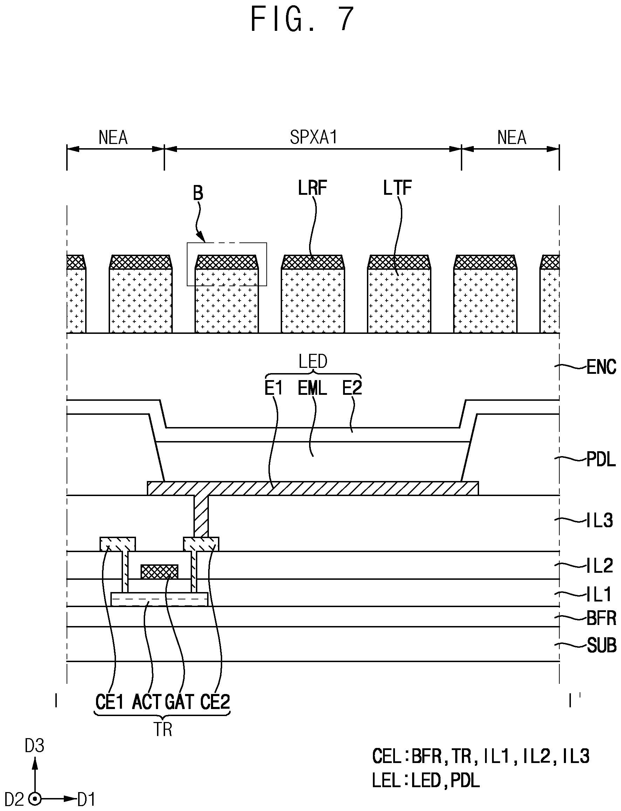

Referring to FIG. 7, the low refractive film LRF may be formed on the light transmitting film LTF. For example, the low refractive film LRF may be formed on the upper surface of the light transmitting film LTF.

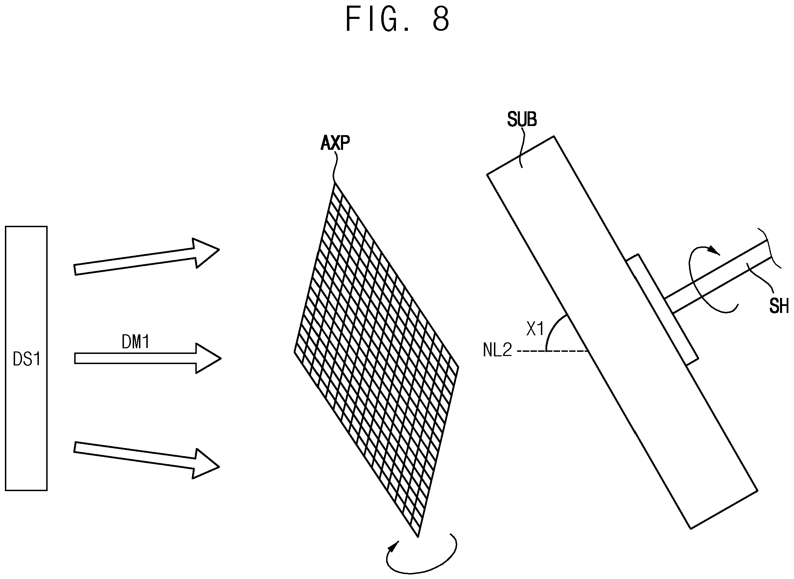

Referring further to FIG. 8, the low refractive film LRF may be formed through an inclined deposition method. A process of forming the low refractive film LRF through the inclined deposition method will be described in more detail hereinafter.

As illustrated in FIG. 8, the substrate SUB may be fixed to a substrate holder SH. At this time, the circuit element layer CEL, the light emitting element layer LEL, the encapsulation layer ENC, and the light transmitting film LTF illustrated in FIG. 6 may be formed on the substrate SUB, but for convenience of illustration, the circuit element layer CEL, the light emitting element layer LEL, the encapsulation layer ENC, and the light transmitting film LTF are not shown in FIG. 8.

The substrate SUB may face a first deposition source DS1 that emits a first deposition material DM1. The substrate SUB may be disposed obliquely at an angle (e.g., a certain or predetermined angle) with respect to a surface from which the first deposition material DM1 is emitted. For example, the substrate SUB may be disposed to be inclined at a first angle X1 with respect to an imaginary line NL2 perpendicular to the surface from which the first deposition material DM1 is emitted.

In an embodiment, the substrate SUB may be rotated by the substrate holder SH. In other words, the low refractive film LRF may be formed while rotating the substrate SUB. However, the present invention is not limited thereto, and in some embodiments, the low refractive film LRF may be formed while the substrate SUB is fixed on the substrate holder SH.

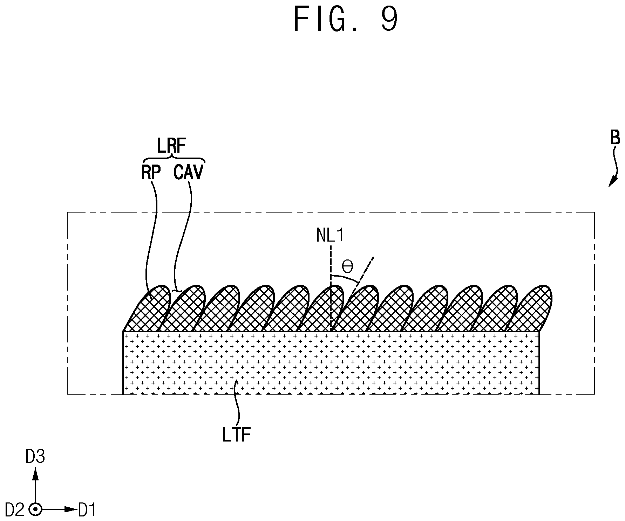

FIG. 9 is an enlarged view of the area B of FIG. 7. Referring further to FIG. 9, as the low refractive film LRF is formed through the inclined deposition method, the low refractive film LRF may be formed in a structure including the refractors RP, and the refractors RP may be formed to be inclined to have the inclination angle θ with respect to the imaginary line NL1 perpendicular to the upper surface of the light transmitting film LTF. For example, as illustrated in FIG. 8, in a case where the substrate SUB is disposed to be inclined at the first angle X1 with respect to the imaginary line NL2 perpendicular to the surface from which the first deposition material DM1 is emitted, the inclination angle θ of each of the refractors RP may be 90 degrees minus the first angle X1 (e.g., 90-X1). However, the present invention is not limited thereto.

As the refractors RP are inclined at a desired angle (e.g., a certain or predetermined angle), the path of the light emitted from the light emitting element LED may be changed by the refractors RP. The inclination angle θ of the refractors RP may be adjusted by variables, such as the injection direction, the injection speed, and/or the deposition direction, of the deposition material in the process according to the inclined deposition method described above with reference to FIG. 8.

In an embodiment, the first deposition material DM1 may include a suitable material having the third refractive index. In other words, the refractors RP may be formed of the material having the third refractive index. Even when the first deposition material DM1 includes the material having the third refractive index greater than the second refractive index, the low refractive film LRF formed through the inclined deposition method and including the refractors RP inclined to have the inclination angle θ may have the second refractive index smaller than the first refractive index of the light transmitting film LTF.

For example, the first deposition material DM1 may include a suitable material having a refractive index greater than or substantially greater than the first refractive index of the light transmitting film LTF. In other words, as the low refractive film LRF is formed through the inclined deposition method, even when the first deposition material DM1 has the refractive index greater than the first refractive index of the light transmitting film LTF, the low refractive film LRF having the refractive index smaller than the first refractive index of the light transmitting film LTF may be provided. Accordingly, a diversity of materials that may be used as the first deposition material DM1 may be secured. As such, it may be easier to form the low refractive film LRF by adopting a deposition material that may reduce or prevent damage during the manufacturing process of the display device DD. Further, the display device DD may be manufactured more easily.

In an embodiment, the first deposition material DM1 may include an inorganic material. In other words, the refractors RP may be formed of one or more inorganic materials. For example, the first deposition material DM1 may include a metal compound and/or an inorganic insulating material. Examples of the metal compound that may be used as the first deposition material DM1 may include magnesium fluoride MgF2 and titanium dioxide TiO2. These materials may be used alone or in suitable combinations with each other. Examples of the inorganic insulating material that may be used as the first deposition material DM1 may include silicon oxide, silicon nitride, and silicon oxynitride. These materials may be used alone or in suitable combinations with each other.

In an embodiment, as illustrated in FIG. 8, an auxiliary plate AXP may be additionally disposed between the substrate SUB and the first deposition source DS1. In other words, the auxiliary plate AXP may be disposed on a path of the first deposition material DM1. In an embodiment, the auxiliary plate AXP may rotate. In other words, the low refractive film LRF may be formed while rotating the auxiliary plate AXP. However, the present invention is not limited thereto, and in some embodiments, the low refractive film LRF may be formed while the auxiliary plate AXP is fixed. The auxiliary plate AXP may have a mesh shape. However, the shape of the auxiliary plate AXP is not limited thereto.

The auxiliary plate AXP may control a direction of progress of the first deposition material DM1. For example, the auxiliary plate AXP may adjust a divergence angle of the first deposition material DM1. Accordingly, when the auxiliary plate AXP is disposed on the path of the first deposition material DM1, it may be easier to selectively deposit the first deposition material DM1 on (e.g., only on) the upper surface of the light transmitting film LTF. Additionally, even when the first deposition source DS1 and the substrate SUB face each other along a horizontal direction parallel to or substantially parallel to the ground, it may be easier to deposit the first deposition material DM1 on the light transmitting film LTF. Accordingly, the low refractive film LRF may be formed more easily. However, the present invention is not limited thereto, and the auxiliary plate AXP may be omitted.

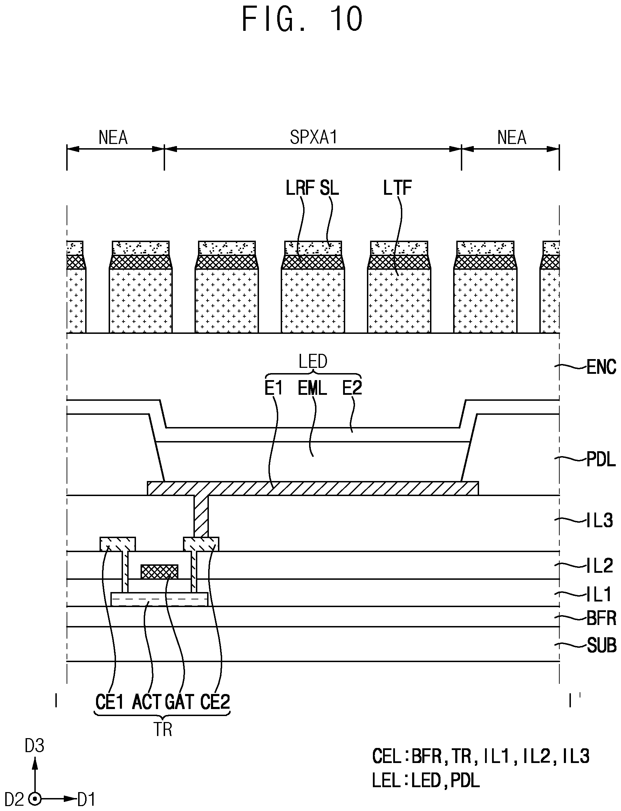

Referring to FIG. 10, a sacrificial layer SL may be formed on the low refractive film LRF. In an embodiment, the sacrificial layer SL may be formed of a transparent conductive oxide. Examples of the transparent conductive oxide that may be used as the sacrificial layer SL may include indium tin oxide (ITO), indium zinc oxide (IZO), indium tin zinc oxide (ITZO), indium gallium zinc oxide (IGZO), indium tin gallium oxide (ITGO), indium tin gallium zinc oxide ITGZO, or the like. These materials may be used alone or in suitable combinations with each other. However, the material that may be used as the sacrificial layer SL is not necessarily limited thereto.

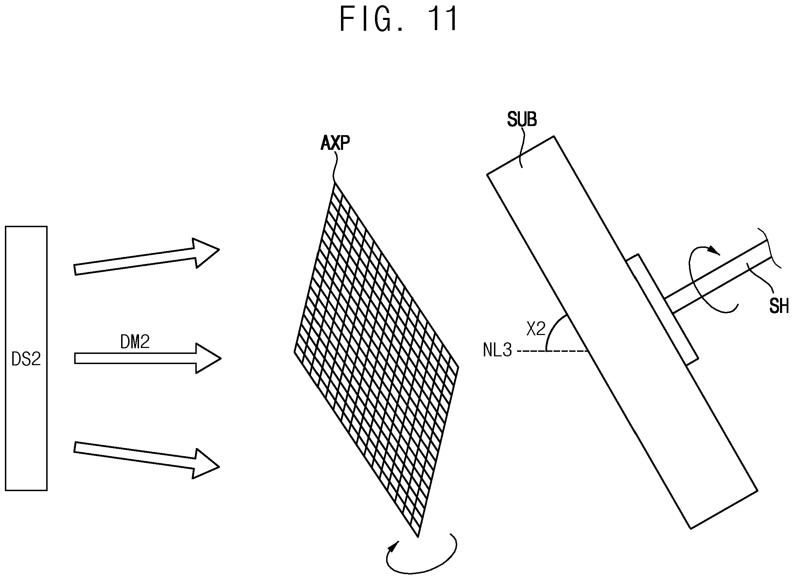

Referring further to FIG. 11, the sacrificial layer SL may be formed through the inclined deposition method. A process of forming the sacrificial layer SL through the inclined deposition method will be described in more detail hereinafter.

Similar to the process of forming the low refractive film LRF, the substrate SUB may be fixed to a substrate holder SH. At this time, the circuit element layer CEL, the light emitting element layer LEL, the encapsulation layer ENC, the light transmitting film LTF, and the low refractive film LRF illustrated in FIG. 7 are formed on the substrate SUB, but for convenience of illustration, the circuit element layer CEL, the light emitting element layer LEL, the encapsulation layer ENC, the light transmitting film LTF, and the low refractive film LRF are not shown in FIG. 11.

The substrate SUB may face a second deposition source DS2 that emits a second deposition material DM2. In an embodiment, the first deposition source DS1 and the second deposition source DS2 in FIG. 8 may be the same. However, the present invention is not limited thereto.

The substrate SUB may be disposed obliquely at an angle (e.g., a certain or predetermined angle) with respect to a surface from which the second deposition material DM2 is emitted. For example, the substrate SUB may be disposed to be inclined at a second angle X2 with respect to an imaginary line NL3 perpendicular to the surface from which the second deposition material DM2 is emitted.

In an embodiment, the imaginary line NL2 perpendicular to the surface from which the first deposition material DM1 is emitted in FIG. 8 and the imaginary line NL3 perpendicular to the surface from which the second deposition material DM2 is emitted may be the same or substantially the same. However, the present invention is not limited thereto.

In an embodiment, the substrate SUB may be rotated by the substrate holder SH. In other words, the sacrificial layer SL may be formed while rotating the substrate SUB. However, the present invention is not limited thereto, and in some embodiments, the sacrificial layer SL may be formed while the substrate SUB is fixed on the substrate holder SH.

As the sacrificial layer SL is formed through the inclined deposition method, the sacrificial layer SL may be formed on the upper surface of the low refractive film LRF, and may not be formed in the openings of the light transmitting film LTF. In other words, the sacrificial layer SL may be selectively formed on the upper surface of the low refractive film LRF.

In an embodiment, the second deposition material DM2 may include a transparent conductive oxide. Examples of the transparent conductive oxide that may be used as the second deposition material DM2 may include indium tin oxide (ITO), indium zinc oxide (IZO), indium tin zinc oxide (ITZO), indium gallium zinc oxide (IGZO), indium tin gallium oxide (ITGO), indium tin gallium zinc oxide (ITGZO), or the like. These materials may be used alone or in suitable combinations with each other. However, the material that may be used as the second deposition material DM2 is not limited thereto.

Even in the process of forming the sacrificial layer SL through the inclined deposition method, the auxiliary plate AXP may be additionally disposed between the substrate SUB and the second deposition source DS2. In other words, the auxiliary plate AXP may be disposed on the path of the second deposition material DM2. Because the auxiliary plate AXP has been described above with reference to FIG. 8, redundant description may not be repeated.

The auxiliary plate AXP may control a direction of progress of the second deposition material DM2. For example, the auxiliary plate AXP may adjust a divergence angle of the second deposition material DM2. Accordingly, when the auxiliary plate AXP is disposed on the path of the second deposition material DM2, it may be easier to selectively deposit the second deposition material DM2 on (e.g., only on) the upper surface of the low refractive film LTF. Additionally, even when the second deposition source DS2 and the substrate SUB face each other along a horizontal direction parallel to the ground, it may be easier to deposit the second deposition material DM2 on the low refractive film LTF. Accordingly, the sacrificial layer SL may be formed more easily. However, the present invention is not limited thereto, and the auxiliary plate AXP may be omitted.

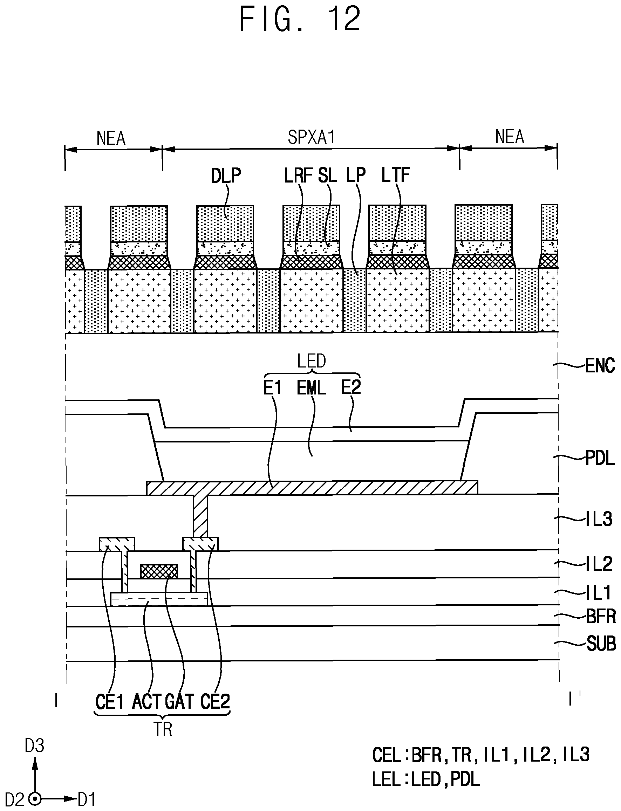

Referring to FIG. 12, the light blocking patterns LP may be formed in the openings of the light transmitting film LTF. In other words, the light blocking patterns LP may be filled in the openings of the light transmitting film LTF. For example, an upper surface of each of the light blocking patterns LP may be formed on the same or substantially the same plane as that of the upper surface of the light transmitting film LTF. The light blocking patterns LP may be formed using a black pigment, a black dye, carbon black, chrome, or the like.

As illustrated in FIG. 12, dummy light blocking patterns DLP may be formed on the sacrificial layer SL.

The dummy light blocking patterns DLP may be formed together with the light blocking patterns LP. In other words, in the process of filling the light blocking patterns LP in the openings of the light transmitting film LTF, the dummy light blocking patterns DLP may be formed on the sacrificial layer SL. In other words, the dummy light blocking patterns DLP may be formed of the same material as that of the light blocking patterns LP. For example, in the process of filling the light blocking patterns LP in the openings of the light transmitting film LTF, the black pigment, the black dye, the carbon black, the chromium, or the like may be accumulated on the sacrificial layer SL to form the dummy light blocking patterns DLP.

The dummy light blocking patterns DLP may be spaced apart from the light blocking patterns LP. In other words, the dummy light blocking patterns DLP and the light blocking patterns LP may be spaced apart from each other by the low refractive film LRF and the sacrificial layer SL. In other words, the dummy light blocking patterns DLP may be selectively formed on the upper surface of the sacrificial layer SL.

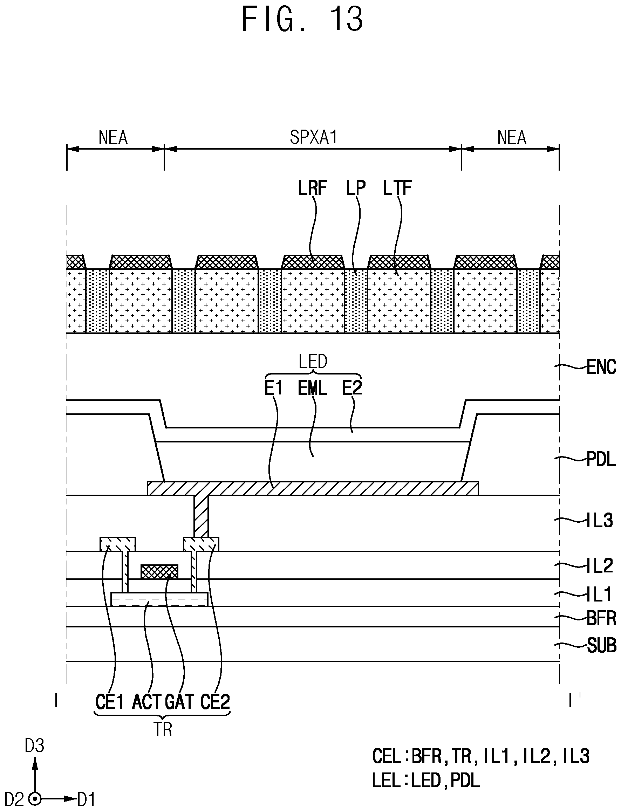

Referring to FIG. 13, the dummy light blocking patterns DLP may be removed by removing the sacrificial layer SL. In other words, because the dummy light blocking patterns DLP may be selectively formed on the upper surface of the sacrificial layer SL, the dummy light blocking patterns DLP may be removed together with the sacrificial layer SL through a process of removing the sacrificial layer SL.

In an embodiment, the sacrificial layer SL may be removed through an etching process. In other words, the sacrificial layer SL may be formed of a suitable material that has a relatively high etch rate in the etching process. For example, the sacrificial layer SL may be completely or substantially completely removed through the etching process. Accordingly, all or substantially all of the dummy light blocking patterns DLP may also be removed.

Even after the dummy light blocking patterns DLP are removed by removing the sacrificial layer SL through the etching process, the low refractive film LRF may remain. In other words, the low refractive film LRF may be formed of a suitable material that has a relatively low etch rate in the etching process. For example, the sacrificial layer SL may be formed of a suitable material having a first etch rate for the etching process, and the low refractive film LRF may be formed of a suitable material having a second etch rate smaller than the first etch rate for the etching process. In more detail, the refractors (e.g., see RP in FIG. 9) included in the low refractive film LRF may be formed to have the second etch rate smaller than the first etch rate. For example, the low refractive film LRF may not be removed or substantially removed by the etching process.

In an embodiment, the etching process may be a wet etching process using an etching solution. For example, the sacrificial layer SL may be completely or substantially completely removed by the wet etching process using the etching solution, and the low refractive film LRF may not be removed or substantially removed by the wet etching process using the etching solution.

However, the present invention is not limited thereto, and the etching process may be a dry etching process using an etching gas. For example, the sacrificial layer SL may be completely or substantially completely removed by the dry etching process using the etching gas, and the low refractive film LRF may not be removed or substantially removed by the dry etching process using the etching gas.

Even after the dummy light blocking patterns DLP are removed by removing the sacrificial layer SL through the etching process, the light blocking patterns LP may remain. In other words, the light blocking patterns LP may not be removed or substantially removed during the process of removing the sacrificial layer SL and the dummy light blocking patterns DLP. In other words, because the dummy light blocking patterns DLP are spaced apart from the light blocking patterns LP, the light blocking patterns LP may not be affected during the process of removing the dummy light blocking patterns DLP.

After removing the sacrificial layer SL and the dummy light blocking patterns DLP, the planarization layer PLN may be formed, as illustrated in FIG. 3. The planarization layer PLN may be formed to cover the light transmitting film LTF, the light blocking patterns LP, and the low refractive film LRF. Additionally, the planarization layer PLN may be formed to fill the cavity (e.g., see CAV in FIG. 9) of the low refractive film LRF.

According to one or more embodiments of the method of manufacturing the display device DD, the low refractive film LRF having a lower refractive index than that of the light transmitting film LTF may be formed on the light transmitting film LTF through the inclined deposition method. By forming the low refractive film LRF through the inclined deposition method, the low refractive film LRF may be selectively formed on the upper surface of the light transmitting film LTF.

In addition, as the low refractive film LRF is formed through the inclined deposition method, even when the low refractive film LRF is formed using a material with a refractive index greater than the refractive index of the light transmitting film LTF, the low refractive film LRF may have a lower refractive index than the refractive index of the light transmitting film LTF. Accordingly, a diversity of materials that may be used as the low refractive film LRF may be secured. Accordingly, it may be easier to implement the low refractive film LRF by adopting a material that may reduce or prevent damage during the manufacturing process of the display device DD. Accordingly, the display device DD may be manufactured more easily.

In addition, according to one or more embodiments of the manufacturing method of the display device DD, the sacrificial layer SL may be formed on the low refractive film LRF, the dummy light blocking patterns DLP may be formed on the sacrificial layer SL, and the dummy light blocking patterns DLP may be removed by removing the sacrificial layer SL. Accordingly, even when a polishing process is omitted, the upper surface of each of the light blocking patterns LP may be formed on the same or substantially the same plane as that of the upper surface of the light transmitting film LTF. In other words, even when the polishing process is omitted, the plane on which the upper surface of each of the light blocking patterns LP and the upper surface of the light transmitting film LTF are formed may be implemented to be flat or substantially flat. In other words, even when the polishing process is omitted, the materials that may be used to form the light blocking patterns LP may not remain or substantially remain on the upper surface of the light transmitting film LTF.

According to one or more embodiments of the manufacturing method of the display device DD, the polishing process for forming the light blocking patterns LP may be omitted. Accordingly, the upper surface of the light transmitting film LTF may not be damaged by the polishing process. As such, surface characteristics of the upper surface of the light transmitting film LTF may be improved. Further, reliability of the display device DD may be improved, and light extraction efficiency of the display device DD may be improved.

The foregoing is illustrative of some embodiments of the present invention, and is not to be construed as limiting thereof. Although some embodiments have been described, those skilled in the art will readily appreciate that various modifications are possible in the embodiments without departing from the present invention. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present invention as defined in the appended claims.

## Claims

1. A display device (DD) comprising:
a light emitting element layer (LEL) comprising at least one light emitting device configured to emit light;
a light transmitting film (LTF) on the light emitting element layer (LEL), the light transmitting film (LTF) having a first refractive index, and defining openings;
a light blocking pattern (LP) on the light emitting element layer (LEL) and in the openings; and
a low refractive film (LRF) on the light transmitting film (LTF), the low refractive film (LRF) having a second refractive index smaller than the first refractive index, and comprising refractors (RP) inclined to have an inclination angle (Θ) with respect to an imaginary line (NL1) perpendicular to an upper surface of the light transmitting film (LTF).

2. The display device (DD) of claim 1, wherein the first refractive index is about 1.4 or more, and the second refractive index is about 1.3 or less.

3. The display device (DD) of claim 1 or 2, wherein each of the refractors (RP) comprises a material having a third refractive index greater than the second refractive index.

4. The display device (DD) of at least one of claims 1 to 3, wherein each of the refractors (RP) comprises an inorganic material.

5. The display device (DD) of claim 4, wherein each of the refractors (RP) comprises at least one of a metal compound or an inorganic insulating material.

6. The display device (DD) of claim 5, wherein each of the refractors (RP) comprises at least one of magnesium fluoride, MgF₂, titanium dioxide, TiO₂, silicon oxide, silicon nitride, or silicon oxynitride.

7. The display device (DD) of at least one of claims 1 to 6, wherein, in a plan view, the low refractive film (LRF) overlaps with the light transmitting film (LTF), and is spaced from the light blocking pattern (LP).

8. The display device (DD) of at least one of claims 1 to 7, wherein the low refractive film (LRF) is not located in the openings.

9. The display device (DD) of at least one of claims 1 to 8, further comprising a planarization layer (PLN) on the light transmitting film (LTF) and the light blocking pattern (LP), and covering the refractors (RP).

10. The display device (DD) of claim 9, wherein the low refractive film (LRF) further comprises a cavity (CAV) defined between the refractors (RP), and the cavity (CAV) of the low refractive film (LRF) is filled by the planarization layer (PLN).

11. The display device (DD) of at least one of claims 1 to 10, wherein the light blocking pattern (LP) comprises at least one of a black pigment, a black dye, or molybdenum-tantalum oxide ,MTO.

12. A method of manufacturing a display device (DD), especially a display device (DD) according to at least one of claims 1 to 11, the method comprising:
forming a light emitting element layer (LEL) on a substrate (SUB), the light emitting layer (LEL) comprising at least one light emitting element configured to emit light;
forming a light transmitting film (LTF) on the light emitting element layer (LEL), the light transmitting film (LTF) having a first refractive index and defining openings;
forming a low refractive film (LRF) on the light transmitting film (LTF), the low refractive film (LRF) having a second refractive index smaller than the first refractive index, and comprising refractors (RP) inclined to have an inclination angle (θ) with respect to an imaginary line (NL1) perpendicular to an upper surface of the light transmitting film (LTF); and
forming a light blocking pattern (LP) in the openings.

13. The method of claim 12, wherein the low refractive film (LRF) is not formed in the openings.

14. The method of claim 12 or 13, wherein, in the forming of the low refractive film (LRF), the low refractive film (LRF) is deposited on the light transmitting film (LTF) by arranging the substrate (SUB) to be inclined with respect to an imaginary line (NL2) perpendicular to a surface from which a deposition material (DM1) used to deposit the low refractive film (LRF) is emitted.

15. The method of claim 14, wherein, in the forming of the low refractive film (LRF), the low refractive film (LRF) is deposited by additionally disposing an auxiliary plate (AXP) to control a direction of progress of the deposition material (DM1) between the surface from which the deposition material (DM1) is emitted and the substrate (SUB).

16. The method of claim 15, wherein the auxiliary plate (AXP) has a mesh shape.

17. The method of at least one of claims 14 to 16, wherein the deposition material (DM1) has a third refractive index greater than the second refractive index.

18. The method of at least one of claims 14 to 17, wherein the deposition material (DM1) comprises an inorganic material.

19. The method of claim 18, wherein the deposition material (DM1) comprises at least one of a metal compound or an inorganic insulating material.

20. The method of at least one of claims 12 to 19, further comprising forming a planarization layer (PLN) on the light transmitting film (LTF) to cover the refractors (RP).

21. The method of at least one of claims 12 to 20, further comprising:
forming a sacrificial layer (SL) on the low refractive film (LRF);
forming a dummy light blocking pattern (DLP) on the sacrificial layer (SL); and
removing the dummy light blocking pattern (DLP) by removing the sacrificial layer (SL),
wherein the dummy light blocking pattern (DLP) is formed in the same process as that of the light blocking pattern (LP).

22. The method of claim 21, wherein the sacrificial layer (SL) is not formed in the openings.

23. The method of claim 21 or 22, wherein, in the forming of the sacrificial layer (SL), the sacrificial layer (SL) is deposited on the low refractive film (LRF) by arranging the substrate (SUB) to be inclined with respect to an imaginary line (NL3) perpendicular to a surface from which a deposition material (DM2) used to deposit the sacrificial layer (SL) is emitted.

24. The method of at least one of claims 21 to 23, wherein, in the removing of the dummy light blocking pattern (DLP), the sacrificial layer (SL) is removed by an etching process.

25. The method of at least one of claim 21 to 24, wherein the sacrificial layer (SL) is formed to have a first etch rate with respect to the etching process, and
wherein the low refractive film (LRF) is formed to have a second etch rate smaller than the first etch rate with respect to the etching process.

26. The method of at least one of claims 21 to 25, wherein the dummy light blocking pattern (DLP) is spaced from the light blocking pattern (LP).

27. The method of at least one of claims 21 to 26, wherein the low refractive film (LRF) and the light blocking pattern (LP) remain after removing the dummy light blocking pattern (DLP) by removing the sacrificial layer (SL).
